# EUROPÄISCHE PATENTSCHRIFT

(11) **EP 2 893 570 B1**
(45) Veröffentlichungstag und Bekanntmachung des Hinweises auf die Patenterteilung: **19.04.2017**
(21) Anmeldenummer: 13776736.4
(22) Anmeldetag: 09.09.2013
(51) Int. Cl.: H01L 31/054, H02S 40/42

(54) **SOLARKOLLEKTOR**
SOLAR COLLECTOR
CAPTEUR SOLAIRE

(30) Priorität: 07.09.2012 WO PCT/IB2012/001743
(43) Veröffentlichungstag der Anmeldung: 15.07.2015
(73) Patentinhaber: Doci Innovations GmbH, 23730 Sierksdorf (DE)
(72) Erfinder: DOCI, Violeta, 22049 Hamburg (DE)
(74) Vertreter: Simandi, Claus
(86) Internationale Anmeldenummer: PCT/EP2013/068649
(87) Internationale Veröffentlichungsnummer: WO 2014/037571

(56) Entgegenhaltungen:
- WO-A1-2011/074535
- AU-A1- 2008 207 559
- US-A- 4 052 228
- US-A- 4 418 238
- US-A- 5 009 243

## Beschreibung

### Gebiet der Erfindung

Die vorliegende Erfindung betrifft einen Solarkollektor oder Lichtkollektor, mit dem Licht, in der Regel Sonnenlicht, auf eine Energiewandlungseinheit gelenkt werden kann. Eine solche Energiewandlungseinheit kann beispielsweise Photovoltaikzellen umfassen.

### Hintergrund der Erfindung

Alternative Energien, beispielsweise Photovoltaik, spielen eine schnell wachsende Rolle für die globale Energieversorgung. Im Bereich der Photovoltaik befasst sich die Forschung intensiv mit der Verbesserung der Effizienz der Solarzellen selbst. Es ist Teil der Einsichten, die der vorliegenden Erfindung zugrunde liegen, dass man auch bei der Art der Nutzung und Anordnung von Solarzellen erhebliche Effizienzgewinne erzielen kann. Allerdings gibt es selbstverständlich auch in diesem Bereich bereits verschiedene Ansätze zur Anordnung von energieerzeugenden Zellen.

Das US-Patent US 5,123,968 beschreibt eine im Wesentlichen zweischichtige Anordnung. In einer ersten Lage sind über eine Fläche verteilt verschiedene Solarzellen aufgebracht. In einer zweiten Lage sind jeweils zentriert über den Solarzellen Linsen, und zwar Fresnel-Linsen vorgesehen. Beide Lagen können durch ein äußeres Gehäuse miteinander verbunden werden.

Das US-Patent US 6,804,062 beschreibt ein ähnliches Konzept, welches aber in Bezug auf die Linsen aufwändiger erscheint. Dort können Fesnel-Linsen mit konventionellen Linsen kombiniert werden.

Die US-Patentanmeldung US 2010/0089436 A1 beschreibt eine Kammer, in der optische Elemente und Solarzellen miteinander kombiniert werden können. Die Kammer umfasst eine kuppelförmige Linse, verschiedene Reflektoren und eine konventionelle bikonvexe Linse. Zwischen diesen Elementen sind Solarzellen vorgesehen. Die optischen Elemente versuchen Licht jeweils optimal auf die Oberfläche einer zugeordneten Solarzelle zu fokussieren.

Die US-Patentanmeldung US 2010/0012186 A1 offenbart eine Kammer, welche eine einer Glühbirne ähnliche Form auffasst. Durch eine flache Oberseite kann Licht eindringen. Mit Hilfe der gegenüberliegenden gewölbten Seite wird dieses Licht gebrochen und im Zentrum konzentriert. In diesem Zentrum befindet sich eine Anordnung von Solarzellen. Dabei können mehrere Solarzellen einen dichten Stapel bilden. Die Kammer kann ferner die erforderliche Regelungselektronik aufnehmen.

Die US-Patentanmeldung US 2010/0252085 offenbart eine leicht transportierbare Solaranlage. Auf einem Stativ-artigen Ständer ist dabei ein großer Reflektorschirm angeordnet. Dieser Reflektorschirm konzentriert Licht auf einen Brennpunkt. In diesem Brennpunkt können Energiewandlungseinheiten vorgesehen sein. Bei diesen Einheiten soll es sich um Halbleiterelemente handeln. Die WO-Patentanmeldung WO 2011/074535 A1 offenbart einen Lichtkollektor, siehe Abb. 2, der eine optische Einheit (20) und eine Energiewandlungseinheit (30) aufweist, wobei die Energiewandlungseinheit aus einer Vielzahl von Wandlungszellen entlang einer Achse besteht. Das einfallende Licht wird in Subspektra durch chromatische Aberration getrennt.

Die vorliegende Erfindung strebt es an, einen Lichtkollektor zur Verfügung zu stellen, der insgesamt kompakter ist, als die aus dem Stand der Technik bekannten Kollektoren. Zugleich soll nichtsdestotrotz seine Effizienz sehr hoch sein. Im Hinblick auf die Effizienz ist nicht nur auf die optischen Eigenschaften zu achten, sondern weil Licht in einem kleinen Bauteil konzentriert wird, auch auf die gute Wärmeableitung. Ferner soll der Lichtkollektor geeignet sein, in Kombination mit einer Vielzahl gleicher Lichtkollektoren, ein ausgedehntes Gitter oder eine Art "Matte" zu bilden.

Diese Vorteile werden durch einen Lichtkollektor nach Anspruch 1 erreicht.

### Nähere Beschreibung der Erfindung

Ein Lichtkollektor im Sinne der Erfindung weist eine optische Einheit und eine Energiewandlungseinheit auf. Die Energiewandlungseinheit kann aus einer Vielzahl von Wandlungszellen bestehen. Die Energie kann dabei in verschiedener Weise gewandelt werden. Beispielsweise kann Licht in Wärme umgewandelt werden. Diese Wärme kann auch von einem geeigneten Medium gespeichert werden, beispielsweise von Wasser. Licht kann aber auch in elektrischen Strom umgewandelt werden. In diesem letzteren Fall würden als Wandlungszellen Photovoltaikzellen (hier auch als "Solarzellen" bezeichnet) eingesetzt werden.

Die Natur der Wandlungszellen oder insbesondere der Solarzellen ist für die vorliegende Erfindung nicht sehr kritisch. Vorzugsweise sind diese Zellen allerdings für eine Miniaturisierung geeignet, so dass sie sich in einen Würfel mit einem Zentimeter Kantenlänge oder weniger gut unterbringen lassen. Die Wandlungszellen können kontinuierlich angrenzend angeordnet sein, vorzugsweise sind sie aber voneinander beabstandet. Im Sinne der vorliegenden Erfindung ist es günstig, wenn sich die Wandlungszellen im Wesentlichen flächig erstrecken, also beispielsweise Plattenform haben.

Die Wandlungszellen sind entlang einer ersten Hauptachse angeordnet. Die Anordnung soll also in eine Richtung ihre hauptsächliche Ausdehnung haben und die erste Hauptachse verläuft in der Richtung dieser hauptsächlichen Ausdehnung. Beispielsweise kann die Anordnung der Wandlungszellen eine Säule beschreiben und die erste Hauptachse ist dann die Längsachse dieser Säule.

Bei der Vielzahl von Wandlungszellen handelt es sich um zwei oder mehr, häufig um drei, vier oder fünf Wandlungszellen.

Die optische Einheit soll die Energiewandlungseinheit zumindest zum Teil umschließen. Das bedeutet, dass die optische Einheit die Energiewandlungseinheit zumindest aus einem Blickwinkel über einen Winkel von 180 Grad oder mehr umschließt. Die optische Einheit kann die Energiewandlungseinheit auch vollständig umschließen. Dies führt dazu, dass die Optik für Lichteinfall aus sehr verschiedenen Richtungen gut genutzt werden kann. Dies kann ferner dazu führen, dass die optische Einheit eine kompakte Einheit mit der Energiewandlungseinheit bildet und evtl. die Anordnung der Energiewandlungseinheit und der einzelnen Wandlungszellen mechanisch stabilisiert.

Die optische Einheit soll eine Lichtbrechung bewirken. Die Lichtbrechung soll dabei so geschehen, dass einfallendes Licht in einem Brennbereich fokussiert wird. Abweichend von typischen Optiken soll Licht also nicht in nur einem Brennpunkt fokussiert werden, sondern in einem ausgedehnten Brennbereich.

Der Brennbereicht kann eine elliptische oder angenähert elliptische Form haben, derart dass der Brennbereich durch eine lange Achse und eine kurze Achse beschrieben wird. Dabei ist zweckmäßig, wenn die lange Achse um mehr als 20% oder 50% oder 100 % oder auch 300% länger als die kurze Achse ist. Sie muss aber nicht mehr als 500% länger als die kurze Achse sein.

Die lange Achse wird hierin auch als zweite Hauptachse bezeichnet. Der Brennbereich hat also seine größte Ausdehnung entlang der zweiten Hauptachse. Diese zweite Hauptachse soll sich entlang der ersten Hauptachse erstrecken.

Es ist zweckmäßig, benachbarte Wandlungszellen in Richtung der Hauptachse in einem ersten gleichen Abstand anzuordnen. Wenn sich die Wandlungszellen im Wesentlichen flächig in einer ersten Erstreckungsebene erstrecken, so ist es zweckmäßig, wenn die Erstreckungsebenen senkrecht zur ersten Hauptachse orientiert sind. Dies bewirkt, dass alle Wandlungszellen in gleicher Weise orientiert sind, so dass es eine einheitliche Richtung für einen optimalen Lichteinfall gibt.

Die Wandlungszellen haben in der Erstreckungsebene eine charakteristische maximale erste Ausdehnung. Diese erste Ausdehnung ist für ein Wandlungszelle in Form einer runden Platte der Durchmesser dieser Platte. Die maximale Ausdehnung für eine quadratische Wandlungszelle wäre die Diagonale des Quadrates. Die maximale Ausdehnung in der Erstreckungsebene ist ein wichtiges Maß, um einen angemessenen Abstand zwischen den Wandlungszellen zu bestimmen. Wenn die Wandlungszellen äquidistant in einem ersten Abstand angeordnet sind, so sollte dieser erste Abstand mindestens 30%, vorzugsweise 50% oder 80% der ersten maximalen Ausdehnung betragen. Ein Abstand von mehr als 200% ist in der Regel nicht erforderlich.

Zweckmäßig sind Wandlungszellen, die elektronischen Strom erzeugen. Typischerweise sind dies also Photovoltaikelemente. Wie erläutert, ist es günstig, wenn die Wandlungszellen beabstandet sind, so dass jede einzelne gut von einfallendem Licht erreicht werden kann. Gerade wenn die einzelnen Zellen sehr klein sind genügt es, filigrane Abstandshalter vorzusehen. Diese können beispielsweise in der Form von Drähten vorgesehen werden. Es ist ein Konzept der vorliegenden Erfindung, eine Doppelnutzung solcher Abstandshalter vorzusehen, bei der diese dann auch als elektrische Leiter dienen. Die Abstandshalter können dann auch erzeugten Strom ableiten.

Zweckmäßig ist es dabei sowohl aus mechanischen wie auch aus Gründen der elektrischen Ansteuerung, mehrere Drähte zu verwenden, mindestens zwei. Es können auch drei oder vier Drähte zweckmäßig sein. Beispielsweise können vier Drähte (oder allgemeine elektrisch leitende Abstandshalter) an den Ecken von rechteckigen Wandlungszellen vorgesehen sein. In dieser Weise lässt sich ein filigraner Stapel von Wandlungszellen bilden.

Vorteilhaft ist es auch, wenn die optische Einheit auf einer Leiterplatte angeordnet ist. Die erwähnten elektrisch leitenden Abstandshalter können dann gleich mit der Leiterplatte verbunden werden. Die Leiterplatte dient der elektrischen Ansteuerung der Wandlungszellen und kann auch der Sammlung und Weiterleitung von erzeugtem Strom dienen. Es können auch mehrere Wandlungszellen und optische Einheiten auf einer Leiterplatte angeordnet werden. Alternativ lassen sich mehrere Lichtkollektoren über ihre Leiterplatten miteinander verbinden.

Vorteilhaft ist es, wenn die Leiterplatte gute Wärmeleitfähigkeit aufweist. Die Leiterplatte sollte in jedem Fall eine bessere Wärmeleitfähigkeit als Luft aufweisen. Vorteilhaft ist es, wenn die Wärmeleitfähigkeit bei 20 Grad Celsius mindestens 0,5 Watt pro Meter und Kelvin beträgt, besser sind Werte von mehr als 1, 5, 10 oder sogar 50 Watt pro Meter und Kelvin.

Ein Grundproblem einer sehr kleinen Lichtkollektoreinheit, in der aber durch eine effiziente optische Einheit viel Licht konzentriert wird, ist die hohe Wärmeentstehung. Die Ableitung von Wärme zumindest über die Leiterplatte ist dann ein entscheidender Vorteil. Die optische Einheit besteht aus einer lichtdurchlässigen Schale und einem Füllmedium. Die lichtdurchlässige Schale kann beispielsweise aus Glas oder Plexiglas gefertigt sein, sie kann aber generell hart oder weich sein. Beispielsweise kommt auch eine Folie in Betracht. Unter einer lichtdurchlässigen Schale ist eine zumindest teilweise lichtdurchlässige Schale zu verstehen. Einzelne Bereiche der Schale können auch lichtundurchlässig sein.

Die Schale kann mit einem gasförmigen oder flüssigen Füllmedium gefüllt sein. Als Füllmedium kommt durchaus Luft in Betracht. Gerade bei einer weichen Schale kann ein stabiler mechanischer Aufbau dadurch erreicht werden, dass diese mit einer Flüssigkeit gefüllt wird. Die Schale sollte dabei im Allgemeinen dicht sein, wenn eine Flüssigkeit verwendet wird, sollten zumindest Teile der Schale das Auslaufen der Flüssigkeit verhindern.

Zweckmäßig ist eine Schale, welche einen planen Teil und einen konvexen Teil aufweist. Der plane Teil der Schale kann eine für den Einbau des Lichtkollektors vorteilhafte Ebene anbieten. Der konvexe Teil der Schale kann Teil der optischen Einheit sein. Dabei kann der konvexe Teil der Schale an der gewünschten Lichtbrechung mitwirken, d. h. an der Fokussierung einfallenden Lichtes in eine Hauptrichtung ausdehnenden Brennbereiches. Der konvexe Teil der Schale ist vorzugsweise parabolisch gewölbt.

Der konvexe Teil der Schale kann auch verspiegelt sein. Dies ist bei einer Anordnung zweckmäßig, bei der Licht durch den planen Teil der Schale fällt und die Fokussierung einfallenden Lichtes durch Reflektion an der Innenseite des konvexen Teils der Schale geschieht. Die optische Einheit weist entlang der ersten Hauptachse einen variablen Brechungsindex für die Lichtbrechung auf. In dieser Weise lässt es sich besonders gut erreichen, dass Licht nicht in einem Punkt fokussiert wird, sondern über einen ausgedehnten Bereich.

Wenn die lichtdurchlässige Schale mit einem Füllmedium gefüllt wird, so können die chemischen oder physikalischen Eigenschaften des Füllmediums entlang der ersten Hauptachse so variieren, dass dadurch eine Veränderung des Brechungsindexes bewirkt wird. Dies ist sowohl dann möglich, wenn das Füllmedium eine Flüssigkeit ist als auch, wenn das Füllmedium ein Gas ist. Als Füllmedien kommen auch Gele in Betracht.

Bei einer Flüssigkeit kann etwa die Dichte der Flüssigkeit variieren, um so in Richtung höherer Flüssigkeitsdichte einen höheren Brechungsindex zu erreichen. Ebenfalls käme es in Betracht, die chemischen Eigenschaften einer Flüssigkeit durch Beimischung eines anderen Stoffes oder in anderer Weise zu verändern. In diesem Sinne kommt es auch in Betracht, zwei oder mehr Flüssigkeiten oder Gase zu verwenden und deren Mischungsverhältnis entlang der ersten Hauptachse zu variieren.

Aus diesen Überlegungen folgt, dass es allgemein ein Konzept der vorliegenden Erfindung ist, einen Lichtkollektor zur Verfügung zu stellen, welcher mindestens eine erste und eine von dieser beabstandete zweite Wandlungszelle aufweist, wobei der ersten Wandlungszelle ein erstes Füllmedium zugeordnet ist und der zweiten Wandlungszelle ein vom ersten Füllmedium verschiedenes zweites Füllmedium zugeordnet ist. Die beiden Füllmedien können chemisch oder physikalisch verschieden sein. Wenn ein Füllmedium einer Wandlungszelle zugeordnet ist, so soll dies heißen, dass Licht, welches die Wandlungszelle erreicht, im Wesentlichen zunächst durch dieses Füllmedium geführt wird. Das Füllmedium kann also an die Wandlungszelle angrenzen oder die Wandlungszelle kann sogar vollständig in dieses Füllmedium eingegrenzt sein. Bei einer Solarzelle wäre das Füllmedium also oberhalb der Lichteinfallsfläche anzuordnen.

Bei der Verwendung von mehreren Wandlungszellen kann selbstverständlich auch ein drittes oder ein viertes Füllmedium verwendet werden. Diese können ebenfalls einzelnen Wandlungszellen zugeordnet sein. Bei geeigneten Medien kommt es in Frage, dass beispielsweise ein gewisser Dichtegradient auch ohne mechanische Abgrenzung der verschiedenen Füllmedien erhalten bleibt. Häufig wird es jedoch zweckmäßig sein, mechanische Abgrenzungen oder Trennwände vorzusehen. Solche Trennwände sollten aus demselben Material wie die äußere Schale sein, um nachteilige optische Effekte zu vermeiden. Zweckmäßige Materialien für die Schale sind Kunststoffe und Halbkristalle. Dementsprechend können auch die Trennwände aus Kunststoff oder Halbkristallen gefertigt sein. Wichtig ist es, dass beim Übergang zwischen verschiedenen Füllmedien der Übergang im Brechungsindex nicht so abrupt ist, dass eine wesentliche Lichtreflektion entsteht.

Im Brennbereich der optischen Einheit soll die Lichtenergie im Vergleich zum einfallenden Licht um einen Faktor 30 oder 50 oder sogar einen Faktor von 100 oder mehr höher sein. Dies bringt die schon angesprochene Herausforderung mit sich, entstehende Wärme gut abzuleiten. Dabei kann auch das Füllmedium eine nützliche Rolle spielen. Dementsprechend ist ein Füllmedium nützlich, welches eine bessere Wärmeleitfähigkeit als Luft aufweist. Wärmeleitfähigkeitswerte wie für die Leiterplatten angegeben sind besonders vorteilhaft. Vorteilhaft ist es also, wenn die Wärmeleitfähigkeit des Füllmediums bei 20 Grad Celsius mindestens 0,5 Watt pro Meter und Kelvin beträgt, besser sind Werte von mehr als 1, 5, 10 oder sogar 50 Watt pro Meter und Kelvin.

Eine nützliche Weiterbildung der Erfindung besteht darin, zumindest Teile der äußeren Schale mit einer Beschichtung auszurüsten, welche Infrarotlicht unterdrückt. Infrarotlicht kann nicht sehr effizient in Energie umgewandelt werden, insbesondere nicht von Photovoltaikzellen. Infrarotlicht führt jedoch zu einer zusätzlichen Wärmeentwicklung, welche bei einer sehr kompakten Bauweise des Lichtkollektors problematisch ist.

Ein großer Vorteil der erfindungsgemäßen Lichtkollektoren ist, dass sie leicht in einem Gitter oder in einer Energieerzeugungsmatte angeordnet werden können. Eine solche Energieerzeugungsmatte umfasst eine Vielzahl von Lichtkollektoren. Sofern für jeden Lichtkollektor eine Leiterplatte vorgesehen ist, können die Lichtkollektoren über die entsprechenden Leiterplatten verbunden werden. Die Leiterplatten bilden dann eine Auflageseite, welche im Wesentlichen eben ist. Diese Auflageseite kann allerdings flexibel sein. In diese Weise lässt sich eine Matte erzeugen, die an der Außenhaut eines Autos oder eines Flugzeuges aufgebracht werden kann, und zwar auch dann, wenn die entsprechenden äußeren Teile gebogen sind.

Die dem Sonnenlicht zugewandte Seite einer solchen Energieerzeugungsmatte kann eine Vielzahl von konvexen Elementen aufweisen. Bei diesen konvexen Elementen könnte es sich um zusätzliche Linsen handeln, zweckmäßigerweise handelt es sich aber um den konvexen Teil der lichtdurchlässigen Schalen von solchen Lichtkollektoren.

Wenn die entsprechende Lichterzeugungsmatte außen an einem Auto oder an einem Flugzeug angebracht wird, ist sie hohen Strömungen ausgesetzt. Bei der Oberfläche, welche eine Vielzahl kleiner konvexer Erhebungen umfasst, ist sie aber bei entsprechender Dimensionierung entsprechend sehr strömungsgünstig. Dieses Prinzip ist beispielsweise von der Außenhaut von Golfbällen interessant. So lassen sich also Strömungsvorteile in einer Weise erreichen, welche zusätzlich den Vorteil einer optisch effizienten Lichtfokussierung haben.

Weitere Merkmale, aber auch Vorteile der Erfindung, ergeben sich aus den nachfolgend aufgeführten Zeichnungen und der zugehörigen Beschreibung. In den Abbildungen und in den dazugehörigen Beschreibungen sind Merkmale der Erfindung in Kombination beschrieben. Diese Merkmale können allerdings auch in anderen Kombinationen von einem erfindungsgemäßen Gegenstand umfasst werden. Jedes offenbarte Merkmal ist also auch als in technisch sinnvollen Kombinationen mit anderen Merkmalen offenbart zu betrachten. Die Abbildungen sind teilweise leicht vereinfacht und schematisch.
- Fig. 1: zeigt ein vertikales Schnittbild durch einen erfindungsgemäßen Lichtkollektor.
- Fig. 2: zeigt ein vertikales Schnittbild durch einen Lichtkollektor in anderer Ausführungsform.
- Fig. 3: zeigt schematisch einen möglichen Lichteinfall in einen solchen Kollektor.
- Fig. 4: zeigt schematisch anhand des Lichteinfalls eine andere Ausführungsform eines Lichtkollektors.

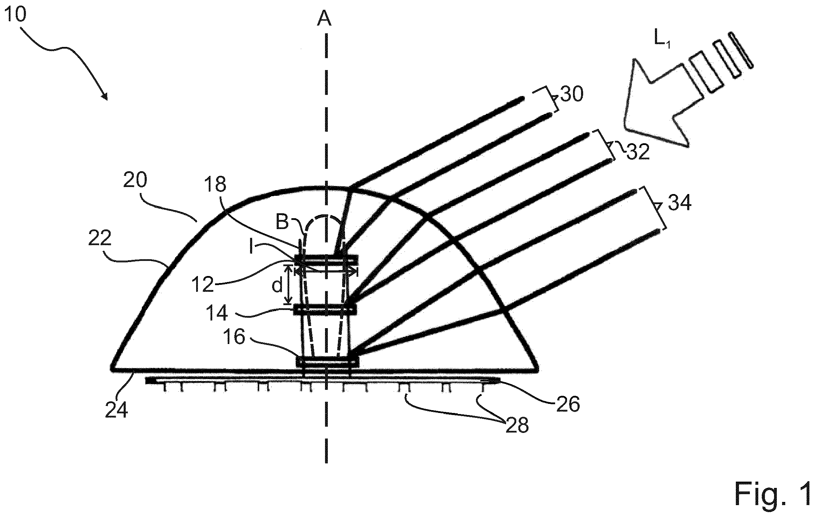

Fig. 1 zeigt in einem vertikalen Schnitt einen erfindungsgemäßen Lichtkollektor 10. Der Lichtkollektor 10 verfügt über drei Wandlungszellen (unter denen man sich beispielsweise Photovoltaikzellen vorstellen kann), eine erste Wandlungszelle 12, darunter angeordnet eine zweite Wandlungszelle 14 und darunter angeordnet eine dritte Wandlungszelle 16. Die drei Wandlungszellen sind durch Abstandshalter 18 miteinander verbunden.
Die Wandlungszellen 12, 14, 16 werden durch eine optische Einheit 20 umschlossen. Die optische Einheit 20 weist eine Schale auf, welche aus einem oberen konvexen Teil 22 besteht und aus einem darunter angeordneten planen Teil 24.

Unterhalb der optischen Einheit 20 ist eine Leiterplatte 26 vorgesehen. Diese erstreckt sich parallel zum planen Teil 24. Sie dient als Trägerelement für die optische Einheit 20. Die Abstandshalter 18 können daher direkt mit der Leiterplatte 26 verbunden werden. Dies sorgt für die mechanische Stabilität der Anordnung und kann zusätzlich zur Leitung elektrischen Stromes genutzt werden. Die Leiterplatte 26 weist Anschlüsse 28 auf. Mit diesen Anschlüssen 28 kann sie mit Leiterplatten benachbarter Lichtkollektoren 10 oder mit sonstigen Einheiten verbunden werden. Die Anschlüsse 28 können auch zur mechanischen Verbindung der Leiterplatte 26 mit anderen Elementen dienen.

Es ist gut erkennbar, dass die Wandlungszellen 12, 14 und 16 eine Art Stapel bilden. Dieser Stapel hat seine hauptsächliche Ausdehnung entlang der ersten Hauptachse A. Die Wandlungszellen erstrecken sich in parallelen Ebenen senkrecht zu dieser Hauptachse A. Jede Wandlungszelle hat eine gewisse maximale Ausdehnung I in dieser Erstreckungsebene. Die entsprechende maximale Ausdehnung I ist für die erste Wandlungszelle 12 eingezeichnet. Die Wandlungszellen haben ferner einen zweckmäßigen Abstand voneinander, welcher als Abstand d zwischen der ersten Wandlungszelle 12 und der zweiten Wandlungszelle 14 eingezeichnet ist. Es ist erkennbar, dass der Abstand d hinreichend groß gewählt ist, um unter Berücksichtigung der Ausdehnung I einen hinreichenden Lichteinfall für jede einzelne Wandlungszelle sicher zu stellen.

Der Verlauf des Lichteinfalls ist bezogen auf die erste Lichteinfallsrichtung L₁ dargestellt. Aus dieser Lichteinfallsrichtung L₁ sollen den Lichtkollektor 10 parallele Strahlen erreichen. Diese sind dargestellt als erstes Strahlenpaar 30, zweites Strahlenpaar 32 und drittes Strahlenpaar 34. Wie man erkennt, ist die optische Einheit 20 so ausgelegt, dass auch die Strahlen genau parallel des einfallenden Lichtes nicht auf einen Brennpunkt fokussiert werden. Vielmehr gibt es eine Reihe von Brennpunkten, welche gemeinsam den Brennbereich B bilden. Dieser Brennbereich B erstreckt sich entlang einer längsten Achse, welche mit der ersten Hauptachse A zusammenfällt. Wie man erkennen kann, wird das Licht des ersten Strahlenpaares 30 im Wesentlichen auf der ersten Wandlungszelle 12 fokussiert. Das Licht des zweiten Strahlenpaares 32 wird dagegen im Wesentlichen auf der zweiten Wandlungszelle 14 fokussiert und das Licht des dritten Strahlenpaares 34 wird im Wesentlichen auf der dritten Wandlungszelle 16 fokussiert. In dieser Weise können alle Wandlungszellen eine annähernd gleiche Energieausbeute erreichen. Im Übrigen werden auch thermische Probleme vermieden, die entstehen, wenn alles Licht in einem zu engen Bereich oder auf einem einzigen Brennpunkt fokussiert wird.

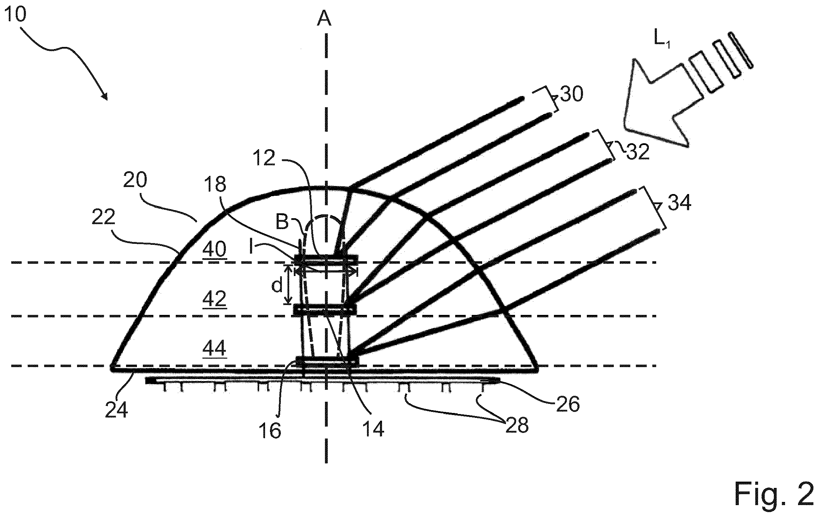

Fig. 2 stellt eine andere Ausführungsform des Lichtkollektors 10 dar. Die Grundelemente der Energiewandlungseinheiten, bestehend aus den Wandlungszellen und den mechanischen Elementen, sind identisch. Im Innern der Schale der optischen Einheit ist jedoch ein komplexerer Aufbau vorgesehen. Im Innern der Schale sollen sich bei dieser Ausführungsform verschiedene Füllmedien befinden, nämlich ein erstes Füllmedium 40 im oberen Bereich, darunter ein zweites Füllmedium 42 und darunter angrenzend an dem planen Teil der Schale 24 ein drittes Füllmedium 44. Diese Füllmedien sollen jeweils verschiedenen Brechungsindex aufweisen. Die Füllmedien können so neben der äußeren Form der Schale die effiziente Lichtbrechung unterstützen. Dadurch wird die Brechung in einen ausgedehnten Brennbereich B effizient erreicht.

Wie man erkennt, ist das erste Füllmedium 40 der ersten Wandlungszelle 12 zugeordnet, d. h. es befindet sich im Wesentlichen oberhalb der Wandlungszelle in Richtung des einfallenden Lichtes. Entsprechend ist das zweite Füllmedium der zweiten Wandlungszelle 14 und das dritte Füllmedium 44 der dritten Wandlungszelle 16 zugeordnet. Die Grenzen zwischen den Füllmedien werden durch Strichelungen repräsentiert. Es kommt durchaus in Frage, an diesen Grenzen feste Trennwände vorzusehen. Diese Trennwände können aus dem gleichen Material wie die Schale gefertigt sein und sich einstückig an dem konvexen Teil 22 der Schale anschließen. Die Trennwände können auch aus einem anderen Material als die Schale bestehen. Sie können mit der Schale fest oder lösbar verbunden sein.

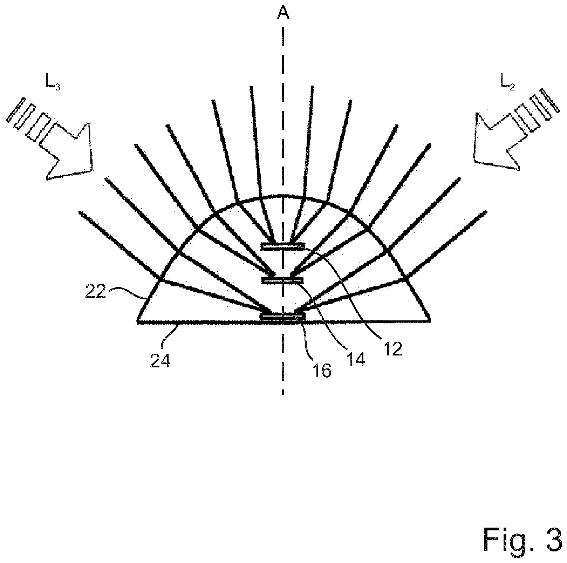

Fig. 3 ist eine schematisch leicht vereinfachte Darstellung eines Lichtkollektors, dessen Grundaufbau dem Lichtkollektor aus Fig. 1 oder Fig. 2 entspricht. In dieser schematischen Darstellung sind nur die äußere Schale mit ihrem konvexen Teil 22 und ihrem planen Teil 24 sowie den drei Wandlungszellen wiederzugeben. Dargestellt ist der Lichteinfall aus zwei Hauptrichtungen, der Lichteinfallsrichtung L₂ und der Lichteinfallsrichtung L₃. Es ist erkennbar, dass auch nicht parallel einfallendes Licht durch die vorgesehene Optik gut auf die verschiedenen Wandlungszellen fokussiert wird. Ferner ist erkennbar, wie vorteilhaft die rotationssymetrische Anordnung um die erste Hauptachse A ist. Licht aus allen Richtungen rund um diese Achse wird gleich gut eingefangen. Bei einer groben Ausrichtung des Lichtkollektors ist es daher möglich, über den Tagesverlauf hinweg bei veränderlichem Sonnenstand eine fast gleichmäßig gute Lichtausbeute zu erreichen. Diese Rotationssymetrie stellt ganz allgemein einen wesentlichen Vorteil der erfindungsgemäßen optischen Anordnung dar.

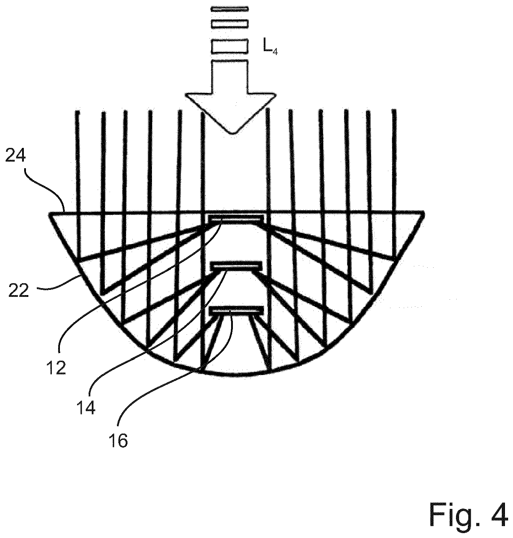

Fig. 4 zeigt in schematischer Darstellung eine andere optische Anordnung. Hier sind wieder drei Wandlungselemente 12, 14 und 16 vorgesehen, welche von einem optischen Element umschlossen werden. Das optische Element weist wiederum einen konvexen Teil 22 und einen planen Teil 24 der Schale auf. In diesem Fall soll der konvexe Teil der Schale jedoch nicht als Linse, sondern als fokussierender Spiegel dienen. Parallel aus der Lichteinfallsrichtung L₄ einfallendes Licht fällt durch den planen Teil der Schale ins Innere des optischen Elementes ein. Es wird am konvexen Teil 22 der Schale reflektiert. Das Licht wird wiederum nicht auf einen Punkt, sondern wird mit guter Ausbeute auf alle drei Wandlungszellen fokussiert.

Anhand der vorangegangenen allgemeinen Beschreibung und der detaillierteren Beschreibung der einzelnen Abbildungen ist deutlich geworden, wie sich aufgrund der vorliegenden Erfindung mechanisch, thermisch und optisch optimierte Lichtkollektoren zur Verfügung stellen lassen, welche sich sogar vorteilhaft in einer Matte kombinieren lassen.

### Bezugszeichenliste

- 10: Lichtkollektor
- 12: erste Wandlungszelle
- 14: zweite Wandlungszelle
- 16: dritte Wandlungszelle
- 18: Abstandshalter
- 20: optische Einheit
- 22: konvexer Teil der Schale
- 24: planer Teil der Schale
- 26: Leiterplatte
- 28: Anschlüsse
- 30: erstes Strahlenpaar
- 32: zweites Strahlenpaar
- 34: drittes Strahlenpaar
- 36: (nicht verwendet)
- 38: (nicht verwendet)
- 40: erstes Füllmedium
- 42: zweites Füllmedium
- 44: drittes Füllmedium
- A: erste Hauptachse
- B: Brennbereich
- I: Ausdehnung
- d: Abstand
- L₁: Lichteinfallsrichtung
- L₂: Lichteinfallsrichtung
- L₃: Lichteinfallsrichtung
- L₄: Lichteinfallsrichtung

## Patentansprüche

1. Lichtkollektor (10), der eine optische Einheit (20) und eine Energiewandlungseinheit aufweist, wobei die Energiewandlungseinheit aus einer Vielzahl von Wandlungszellen (12, 14, 16) besteht, welche entlang einer ersten Hauptachse angeordnet sind, **dadurch gekennzeichnet, dass** die optische Einheit (20) eine Lichtbrechung bewirkt und die Energiewandlungseinheit zumindest zum Teil umschließt und dass die optische Einheit (20) parallel einfallendes Licht in einem Brennbereich fokussiert, wobei der Brennbereich seine größte Ausdehnung entlang einer zweiten Hauptachse hat und die zweite Hauptachse sich entlang der ersten Hauptachse erstreckt, und wobei die optische Einheit (20) aus einer lichtdurchlässigen Schale und einem Füllmedium besteht, und die optische Einheit (20) einen entlang der ersten Hauptachse variablen Brechungsindex für die Lichtbrechung aufweist.

2. Lichtkollektor (10) nach Anspruch 1, wobei die Wandlungszellen (12, 14, 16) voneinander beabstandet angeordnet sind und die Wandlungszellen (12, 14, 16) sich im Wesentlichen flächig erstrecken und in der Erstreckungsebene eine erste maximale Ausdehnung haben.

3. Lichtkollektor (10) nach Anspruch 1 oder 2, wobei die Erstreckungsebenen senkrecht zur ersten Hauptachse orientiert sind und benachbarte Wandlungszellen (12, 14, 16) in Richtung der Hauptachse einen gleichen ersten Abstand aufweisen.

4. Lichtkollektor (10) nach Anspruch 3, wobei die Wandlungszellen (12, 14, 16) sich im Wesentlichen flächig erstrecken und in der Erstreckungsebene eine erste maximale Ausdehnung haben und wobei der erste Abstand mindestens 30%, vorzugsweise mindestens 50% der ersten maximalen Ausdehnung betragen.

5. Lichtkollektor (10) nach einem der vorhergehenden Ansprüche, wobei die Wandlungszellen (12, 14, 16) elektrischen Strom erzeugen und zwischen den Wandungszellen Abstandshalter vorgesehen sind, welche auch als elektrische Leiter dienen können, insbesondere zur Ableitung von Strom.

6. Lichtkollektor (10) nach Anspruch 1, wobei die optische Einheit (20) (20) auf einer Leiterplatte angeordnet ist.

7. Lichtkollektor (10) nach Anspruch 1, wobei die optische Einheit (20) (20) die Energiewandlungseinheit vollständig umschließt.

8. Lichtkollektor (10) nach Anspruch 1, wobei die lichtdurchlässige Schale einen gewölbten, vorzugsweise parabolisch gewölbten Teil aufweist.

9. Lichtkollektor (10) nach Anspruch 1, wobei das Füllmedium mindestens ein Gas oder mindestens eine Flüssigkeit umfasst.

10. Lichtkollektor (10) nach Anspruch 1, wobei die physikalischen Eigenschaften des mindestens einen Gases oder der mindestens einen Flüssigkeit entlang der ersten Hauptachse so variieren, dass dadurch eine Veränderung des Brechungsindexes bewirkt wird

11. Lichtkollektor (10) nach Anspruch 1, welches eine erste Wandlungszelle (12) und eine von dieser beabstandete zweite Wandlungszelle (14) aufweist und der ersten Wandlungszelle (12) ein erstes Füllmedium und der zweiten Wandlungszelle (14) ein vom ersten Füllmedium (40) verschiedenes zweites Füllmedium (42) zugeordnet ist.

12. Lichtkollektor (10) nach Anspruch 1, bei welchem das Füllmedium eine bessere Wärmeleitfähigkeit als Luft aufweist, vorzugsweise bei 20 Grad C mehr als 0,5 W / (m x K), besser mehr als 1 oder 5 oder 10 W / (m x K).

13. Energieerzeugungsmatte, welche aus einer Vielzahl von Lichtkollektoren (10) nach einem der vorhergehenden Ansprüche besteht, wobei die Matte eine Auflageseite aufweist, welche im Wesentlichen eben ist, und eine sonnenlichtzugewandte Seite aufweist, welche aus einer Vielzahl von konvexen Elementen besteht, die Teil der optischen Einheit der Lichtkollektoren (10) sind.

## Claims

1. A light collector (10) having an optical unit (20) and an energy conversion unit, whereby the energy conversion unit consists of a number of conversion cells (12, 14, 16) that are located along a first main axis, in which the optical unit (20) triggers a light refraction and encloses the energy conversion unit at least partially, and the optical unit (20) focuses parallel incident light on a focal area, wherein the focal area has its largest dimension along a second main axis, and the second main axis extends along the first main axis, and wherein the optical unit (20) consists of a light-transmitting dish and a fill medium, and the optical unit (20) has a variable index of refraction along the first main axis for the refraction of light.

2. A light collector (10) as recited in Claim 1, wherein the conversion cells (12, 14, 16) are located at a distance from each other and essentially extend two-dimensionally and have a first maximum dimension in the plane of the extension.

3. A light collector (10) as recited in Claim 1 or 2, wherein the planes of extension are oriented perpendicular to the first main axis and the adjacent conversion cells (12, 14, 16) have the same first distance to each other in the direction toward the main axis.

4. A light collector (10) as recited in Claim 3, in which the conversion cells (12, 14, 16) extend essentially two-dimensionally and have a first maximum dimension in the plane of extension and wherein the first distance is at least 30%, preferably at least 50% of the first maximum dimension.

5. A light collector (10) as recited in one of the preceding Claims,
wherein the conversion cells (12, 14, 16) generate electric current and spacers are provided between the conversion cells which can also function as electric conductors, in particular, to divert electric current.

6. A light collector (10) as recited in Claim 1, wherein the optical unit (20) (20) is located on a printed circuit board.

7. A light collector (10) as recited in Claim 1, wherein the optical unit (20) (20) surrounds the energy conversion unit completely.

8. A light collector (10) as recited in Claim 1, wherein the light-transmitting dish has an arched, preferably a parabolically arched part.

9. A light collector (10) as recited in Claim 1, wherein the fill medium comprises at least one gas or at least one liquid.

10. A light collector (10) as recited in Claim 1, wherein the physical properties of the at least one gas or the at least one liquid along the first main axis vary in such a way that a change in the index of refraction is triggered thereby.

11. A light collector (10) as recited in Claim 1 that has a first conversion cell (12) and at a distance from it, a second conversion cell (14), and the first conversion cell (12) is dedicated to a first fill medium and the second conversion cell (14) is dedicated to a fill medium (42) that is different from the first fill medium (40).

12. A light collector (10) as recited in Claim 1, in which the fill medium has a thermal conductivity that is better than that of air, preferably more than 0.5w/(m x K), better more than 1 or 5 or 10w/(m x K) at 20 degrees Centigrade.

13. An energy generation mat consisting of a number of light collectors (10) as recited in one of the preceding Claims, wherein the mat has a bearing side that is essentially flat and a side that faces the sunlight that consists of a number of convex elements that are components of the optical unit of the light collectors (10).

## Revendications

1. Collecteur de lumière (10) ayant une unité optique (20) et une unité de conversion d'énergie, où l'unité de conversion d'énergie consiste en un grand nombre de cellules de conversion (12, 14, 16) qui sont situées le long d'un premier axe principal, dans lesquelles l'unité optique (20) déclenche une réfraction de la lumière et entoure au moins partiellement l'unité de conversion d'énergie, et l'unité optique (20) focalise parallèlement de la lumière incidente sur une zone focale,
où la zone focale possède sa plus grande dimension le long d'un second axe principal, et le second axe principal s'étend le long du premier axe principal, et où l'unité optique (20) consiste en une cuvette de transmission de lumière et d'un milieu de remplissage, et l'unité optique (20) a un indice de réfraction variable le long du premier axe principal pour la réfraction de la lumière.

2. Collecteur de lumière (10) selon la revendication 1, dans lequel les cellules de conversion (12, 14, 16) sont situées à distance les unes des autres et s'étendent essentiellement dans deux dimensions et ont une première dimension maximale dans le plan de l'extension.

3. Collecteur de lumière (10) selon la revendication 1 ou 2, dans lequel les plans d'extension sont orientés perpendiculairement au premier axe principal et les cellules de conversion (12, 14, 16) adjacentes ont la même première distance les unes par rapport aux autres dans la direction vers l'axe principal.

4. Collecteur de lumière (10) selon la revendication 3, dans lequel les cellules de conversion (12, 14, 16) s'étendent essentiellement dans deux dimensions et ont une première dimension maximale dans le plan d'extension et où la première distance est égale à au moins 30 %, de préférence au moins 50 % de la première dimension maximale.

5. Collecteur de lumière (10) selon l'une des revendications précédentes, dans lequel les cellules de conversion (12, 14, 16) génèrent un courant électrique et des espaceurs sont mis en place entre les cellules de conversion qui peuvent également fonctionner en tant que conducteurs électriques, en particulier pour détourner du courant électrique.

6. Collecteur de lumière (10) selon la revendication 1, dans lequel l'unité optique (20) (20) est située sur une carte de circuit imprimé.

7. Collecteur de lumière (10) selon la revendication 1, dans lequel l'unité optique (20) (20) entoure complètement l'unité de conversion d'énergie.

8. Collecteur de lumière (10) selon la revendication 1, la cuvette de transmission de lumière a une partie arquée, de préférence, arquée de manière parabolique.

9. Collecteur de lumière (10) selon la revendication 1, dans lequel le milieu de remplissage comprend au moins un gaz ou au moins un liquide.

10. Collecteur de lumière (10) selon la revendication 1, dans lequel les propriétés physiques de l'au moins un gaz ou de l'au moins un liquide varient le long du premier axe principal d'une telle manière qu'une variation dans l'indice de réfraction en est déclenchée.

11. Collecteur de lumière (10) selon la revendication 1 qui a une première cellule de conversion (12) et à une distance de celle-ci, une seconde cellule de conversion (14), et la première cellule de conversion (12) est destinée à un premier milieu de remplissage et la seconde cellule de conversion (14) est destinée à un milieu de remplissage (42) qui est différent du premier milieu de remplissage (40).

12. Collecteur de lumière (10) selon la revendication 1, dans lequel le milieu de remplissage a une conductivité thermique qui est meilleure que celle de l'air, de préférence supérieure de 0,5 w/(m x K), meilleure de plus de 1 ou de 5 ou de 10 w/(m x K) à 20 degrés Centigrade.

13. Tapis de génération d'énergie consistant en un grand nombre de collecteurs de lumière (10) selon l'une des revendications précédentes, où le tapis a un côté de support qui est essentiellement plan et un côté qui fait face à la lumière solaire qui consiste en un grand nombre d'éléments convexes qui sont des composants de l'unité optique des collecteurs de lumière (10).
